# EUROPEAN PATENT APPLICATION

(11) **EP 4 757 514 A1**
(43) Date of publication of application: **10.06.2026**
(21) Application number: 24848301.8
(22) Date of filing: 31.07.2024
(51) Int. Cl.: H05K 7/20, H01M 10/6557

(54) **COOLING PLATE ASSEMBLY**

(30) Priority: 31.07.2023 CN 202310956752
(71) Applicant: Shaoxing Sanhua Automotive Thermal Management Technology Co., Ltd., Shaoxing, Zhejiang 312000 (CN)
(72) Inventor: SHAN, Fangjian, Shaoxing, Zhejiang 312000 (CN); LIANG, Qinglei, Shaoxing, Zhejiang 312000 (CN); SHEN, Jiahuan, Shaoxing, Zhejiang 312000 (CN); LI, Hua, Shaoxing, Zhejiang 312000 (CN)
(74) Representative: Epping - Hermann - Fischer
(86) International application number: PCT/CN2024/108760
(87) International publication number: WO 2025/026346

(57) **Abstract**

A cooling plate assembly, comprising a first cooling plate, a second cooling plate, and a connecting member. The first cooling plate and the second cooling plate each comprise a mounting potion; and the connecting member is sealedly connected to mounting potions. The cooling plate assembly comprises a positioning potion. In an assembly direction of the mounting potions and the connecting member, the positioning potion limits the relative movement of the connecting member and the mounting potions. In the assembly direction of the mounting potions and the connecting member, the cooling plate assembly limits the relative movement of the connecting member and the mounting portions by means of the positioning portion. That is, during assembly, the positioning portion achieves a blocking effect on the connecting member or the mounting portions, so as to position the assembly, thereby reducing the mounting difficulty.

## Description

The present application claims the priority to Chinese Patent Application No. 202310956752.4, titled "COOLING PLATE ASSEMBLY", filed with the China National Intellectual Property Administration on July 31, 2023, which is incorporated herein by reference in its entirety.

### FIELD

The present application relates to the technical field of thermal management and, in particular, to a cooling plate assembly.

### BACKGROUND

A combination of a casing pipe and metal male connectors is typically used for connecting two cooling plates, that is, both ends of the casing pipe are respectively assembled with the metal male connectors. Because the insertion depths of the metal male connector into the casing pipe during assembly cannot be directly observed, the force applying on both ends of the casing pipe and the assembly time period are typically used to indirectly estimate the insertion depth, which makes the assembly process difficult.

### SUMMARY

An object of the present application is to provide a cooling plate assembly, and the structure of the cooling plate assembly is beneficial for assembly positioning, which reduces the installation difficulty.

A cooling plate assembly is provided according to an embodiment of the present application. The cooling plate assembly includes a first cooling plate, a second cooling plate, and a first connecting member. The second cooling plate and the first cooling plate each include a first match part, and the first connecting member is configured to form a fluid-tight connection to the first match part. The cooling plate assembly further includes a position-limiting part, and, in an assembly direction of the first match parts and the first connecting member, a relative movement of the first connecting member and the first match parts is restricted by the position-limiting part.

In the above solutions, in the assembly direction of the first match parts and the first connecting member, the relative movement of the first connecting member and the first match parts in the cooling plate assembly is restricted by the position-limiting part. That is, during assembly, the position-limiting part functions as a stop for the first connecting member and the first match parts, thus an assembly length of the first connecting member and the first match part is fixed, and the position-limiting part implements a position-limiting function, which reduces the installation difficulty.

### BRIEF DESCRIPTION OF THE DRAWINGS

FIG. 1 is a schematic structural view of a cooling plate assembly according to a first embodiment of the present application;
FIG. 2 is a schematic structural view along a line B-B in FIG. 1;
FIG. 3 is a schematic sectional structural view of a first connecting member and a first match part along a line C-C in FIG. 2 according to a first embodiment;
FIG. 4 is a schematic structural view of the first connecting member according to a first embodiment of the present application;
FIG. 5 is a schematic structural view of the first connecting member according to a second embodiment of the present application;
FIG. 6 is a schematic structural view of the first connecting member according to a third embodiment of the present application;

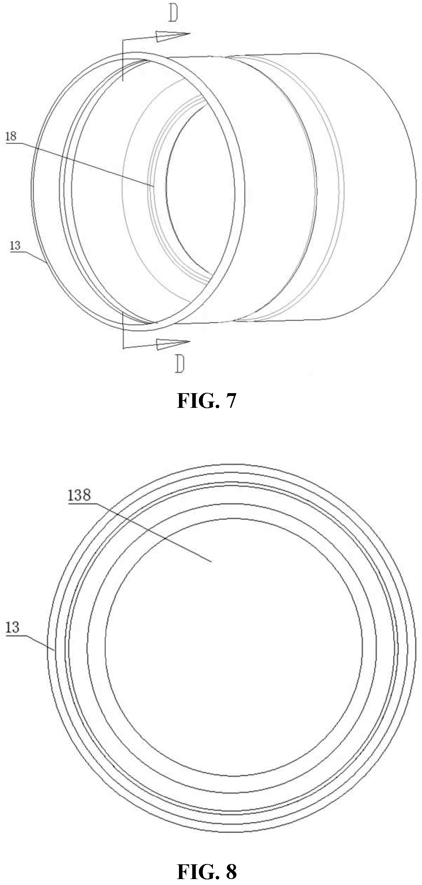

FIG. 7 is a schematic structural view of the first connecting member in FIG. 1;
FIG. 8 is a schematic structural view along a line D-D in FIG. 7;

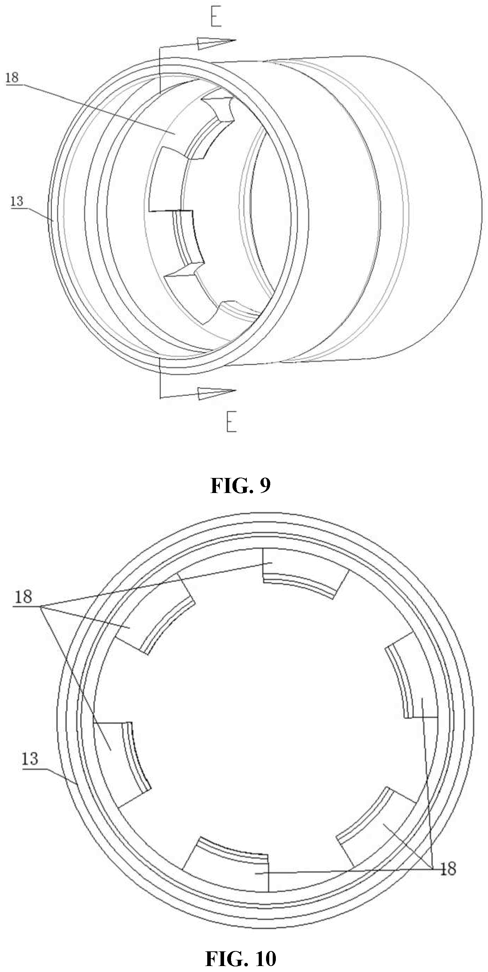

FIG. 9 is a schematic structural view of a position-limiting part in FIG. 7 according to another embodiment;
FIG. 10 is a schematic structural view along a line E-E in FIG. 9;
FIG. 11 is a schematic partially enlarged structural view at a portion F in FIG. 3;
FIG. 12 is a schematic structural view of the first match part according to a first embodiment of the present application;
FIG. 13 is a schematic structural view of the first match part according to a second embodiment of the present application;
FIG. 14 is a schematic structural view of the first match part according to a third embodiment of the present application;
FIG. 15 is a schematic structural view of the first match part according to a fourth embodiment of the present application;
FIG. 16 is another schematic assembled structural view of a cooling plate assembly according to the present application;
FIG. 17 is a schematic sectional structural view of FIG. 16;
FIG. 18 is a schematic assembled structural view of the first connecting member and the first match part according to a second embodiment of the present application;
FIG. 19 is a schematic assembled structural view of the first connecting member and the first match part according to a third embodiment of the present application;
FIG. 20 is a schematic assembled structural view of the first connecting member and the first match part according to a fourth embodiment of the present application;
FIG. 21 is a schematic assembled structural view of the first connecting member and the first match part according to a fifth embodiment of the present application;
FIG. 22 is a schematic assembled structural view of the first connecting member and the first match part according to a sixth embodiment of the present application;
FIG. 23 is a schematic assembled structural view of the first connecting member and the first match part according to a seventh embodiment of the present application;
FIG. 24 is a schematic assembled structural view of the first connecting member and the first match part according to an eighth embodiment of the present application;
FIG. 25 is a schematic sectional structural view of the cooling plate assembly according to a second embodiment of the present application;
FIG. 26 is a partially enlarged view at a portion B in FIG. 25;
FIG. 27 is a schematic structural view of a first sealing part, a ribbed part and the first connecting member in the cooling plate assembly according to a first embodiment of the present application;
FIG. 28 is a schematic structural view of the first sealing part, the ribbed part and the first connecting member in the cooling plate assembly according to a second embodiment of the present application;
FIG. 29 is a schematic structural view of the first connecting member and the first match part in FIG. 27;
FIG. 30 is a partially enlarged view at a portion C in FIG. 29;
FIG. 31 is a schematic structural view of the first connecting member in FIG. 29 before being assembled;
FIG. 32 is a schematic sectional structural view of a cooling plate assembly according to a third embodiment of the present application;
FIG. 33 is a schematic structural view of the first connecting member in FIG. 32 before being assembled;
FIG. 34 is a partially enlarged view at a portion E in FIG. 33;
FIG. 35 is a schematic sectional structural view of the cooling plate assembly according to a fourth embodiment of the present application;
FIG. 36 is a partially enlarged view of the first embodiment at a portion F in FIG. 35;
FIG. 37 is a schematic structural view of the first connecting member in FIG. 35 before being assembled;
FIG. 38 is a partially enlarged view at a portion G in FIG. 37;
FIG. 39 is a partially enlarged view of the second embodiment at a portion F in FIG. 35;
FIG. 40 is a schematic structural view of the first connecting member in FIG. 39 before being assembled;
FIG. 41 is a schematic sectional structural view of the cooling plate assembly according to a fifth embodiment of the present application;
FIG. 42 is a schematic structural view of the first connecting member and the first match part in FIG. 41;
FIG. 43 is a partially enlarged view at a portion H in FIG. 42;
FIG. 44 is a schematic structural view of the first match part in FIG. 41 before being assembled;
FIG. 45 is a partially enlarged view of the second embodiment at the portion H in FIG. 42;
FIG. 46 is a schematic structural view of the first match part in FIG. 45 before being assembled;
FIG. 47 is a schematic sectional structural view of the cooling plate assembly according to a sixth embodiment of the present application;
FIG. 48 is a partially enlarged view at a portion I in FIG. 47;
FIG. 49 is a schematic structural view of the first match part in FIG. 47 before being assembled;
FIG. 50 is a schematic sectional structural view of the cooling plate assembly according to a seventh embodiment of the present application;
FIG. 51 is a schematic sectional structural view of the cooling plate assembly according to an eighth embodiment of the present application;
FIG. 52 is a schematic sectional structural view of the cooling plate assembly according to a ninth embodiment of the present application;
FIG. 53 is a schematic structural view of the connecting part in the cooling plate assembly according to the present application;
FIG. 54 is a schematic sectional structural view of the cooling plate assembly according to a tenth embodiment of the present application; and
FIG. 55 is a schematic sectional structural view of the cooling plate assembly according to an eleventh embodiment of the present application.

Numeral references are listed below:
13 first connecting member, 111 connecting portion, 138 second section, 137 first section, 18 position-limiting part, 1122 connecting hole, 15 first sealing part, 114 reinforcing part, 12 second cooling plate, 14 first match part, 112 match portion, 1311 large-diameter section, 1312 small-diameter section, 11 first cooling plate.

### DETAILED DESCRIPTION OF THE EMBODIMENTS

Hereinafter, specific implementation examples will be described in detail with reference to the accompany drawings. In order to fully understand the present application, numerous specific details are mentioned in the following detailed description. However, those skilled in the art should understand that the specific components, devices, and features illustrated in the accompany drawings and described herein are merely exemplary, which should not be construed as limiting.

### Embodiment 1

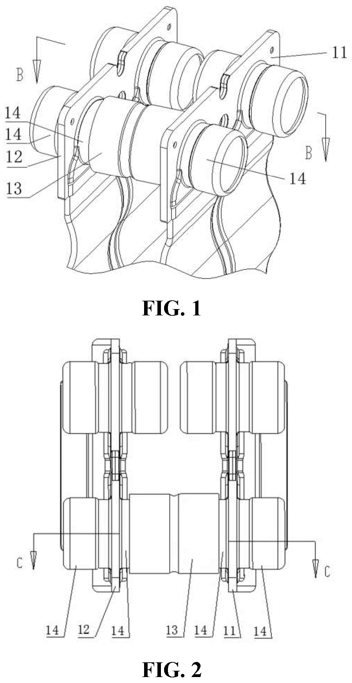

Reference is made to Embodiment 1 shown in FIG. 1 to FIG. 3. A cooling plate assembly is provided in this embodiment, which includes a first cooling plate 11, a second cooling plate 12, and a first connecting member 13. The second cooling plate 12 and the first cooling plate 11 each include a first match part 14, and the first connecting member 13 is configured to form a fluid-tight connection with the first match part 14. A fluid flows through the first match part 14 of the second cooling plate 12 to the first connecting member 13, and then flows through the first match part 14 of the first cooling plate 11 to the first cooling plate 11. The cooling plate assembly includes a position-limiting part 18. In an assembly direction of the first match parts 14 and the first connecting member 13, a relative movement of the first connecting member 13 and the first match parts 14 is restricted by the position-limiting part 18. During assembly, the position-limiting part 18 functions as a stop so as to limit a maximum insertion depth of an assembling part of the first connecting member 13 and the first match part 14, and thus the position-limiting part 18 implements a position-limiting function, which reduces the installation difficulty.

### Embodiment 2

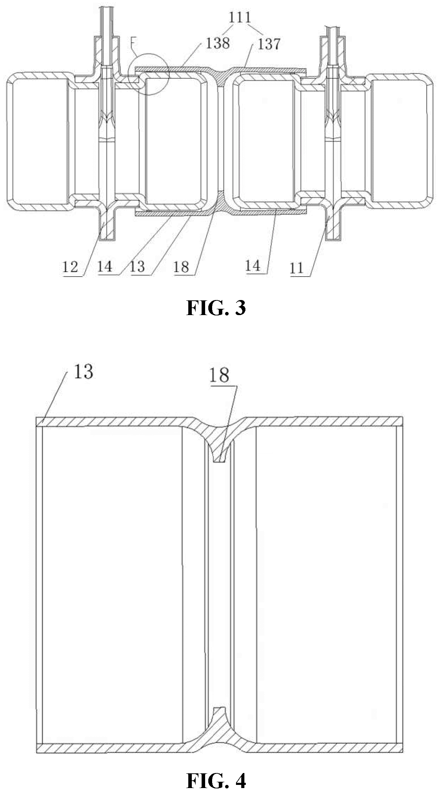

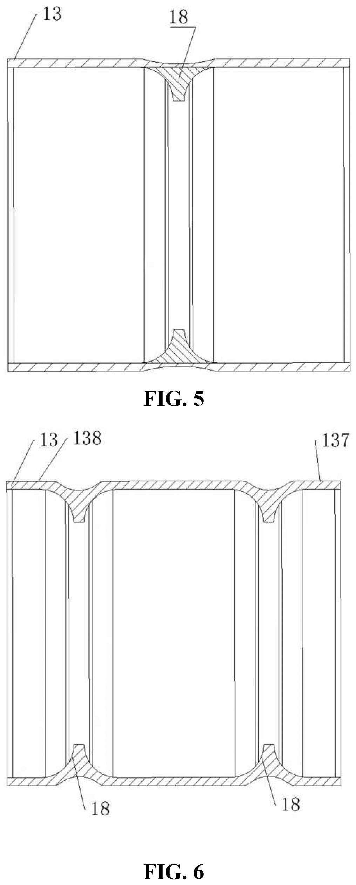

Reference is made to Embodiment 2 shown in FIG. 1 to FIG. 6. A cooling plate assembly is provided in this embodiment, which includes a second cooling plate 12, a first cooling plate 11, and a first connecting member 13. The second cooling plate 12 and the first cooling plate 11 each include a first match part 14, and the first connecting member 13 is configured to form a fluid-tight connection with the first match part 14. A fluid flows through the first match part 14 of the second cooling plate 12 to the first connecting member 13, and then flows through the first match part 14 of the first cooling plate 11 to the first cooling plate 11. The cooling plate assembly includes a position-limiting part 18. In a radial direction of the first connecting member 13, the first connecting member 13 is located on an outer periphery of the first match part 14, and the position-limiting part 18 is fixedly connected to the first connecting member 13. It should be noted that the fixed connection in the context may be an integrated structure of the position-limiting part 18 and the first connecting member 13. For example, the position-limiting part 18 is formed by the first connecting member 13 recessing inwards in the radial direction of the first connecting member 13, as shown in FIG. 4. Alternatively, the position-limiting part 18 may be fixed to the first connecting member 13 by processing, for example, the position-limiting part 18 may be fixedly connected to the first connecting member 13 by welding, as shown in FIG. 5. In the assembly direction of the first match part 14 and the first connecting member 13, the position-limiting part 18 abuts against the first match part 14, and a further relative movement of the first connecting member 13 and the first match parts 14 is restricted by the position-limiting part 18. During assembly, the position-limiting part 18 functions as a stop so as to limit the maximum insertion depth of the assembling part of the first connecting member 13 and the first match part 14, and thus the position-limiting part 18 implements a position-limiting function, which reduces the installation difficulty.

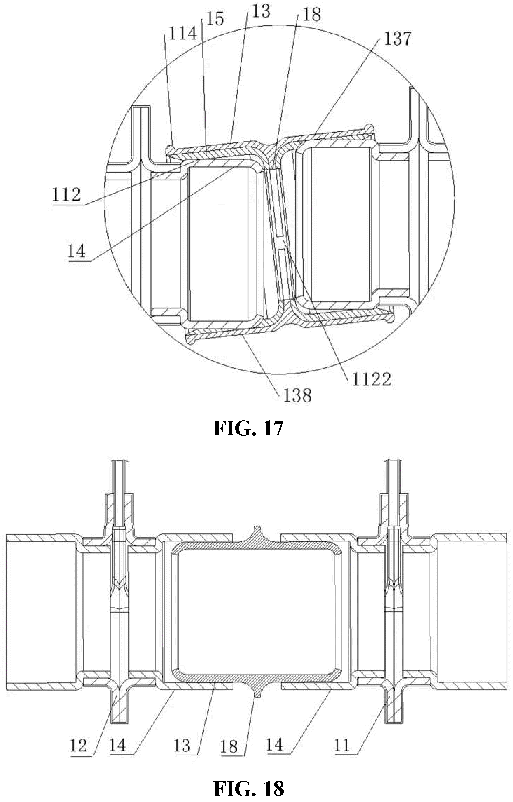

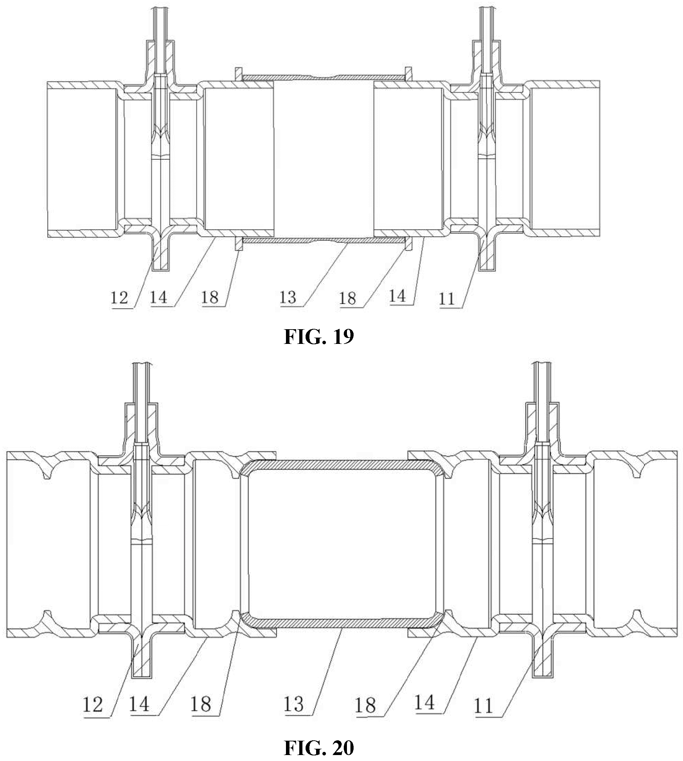

In the embodiment, in the radial direction of the first connecting member 13, the first connecting member 13 is located on the outer periphery of the first match part 14, and the position-limiting part 18 is fixedly connected to the first connecting member 13 and abuts against the first match part 14. Or, as shown in FIG. 19, in the radial direction of the first connecting member 13, the first connecting member 13 is located on the outer periphery of the first match part 14, and the position-limiting part 18 is fixedly connected to the first match part 14 and abuts against the first connecting member 13. Or, as shown in FIG. 18, in the radial direction of the first connecting member 13, the first match part 14 is located on the outer periphery of the first connecting member 13, and the position-limiting part 18 is fixedly connected to the first connecting member 13 and abuts against the first match part 14. Or, as shown in FIG. 20, in the radial direction of the first connecting member 13, the first match part 14 is located on the outer periphery of the first connecting member 13, and the position-limiting part 18 is fixedly connected to the first match part 14 and abuts against the first connecting member 13.

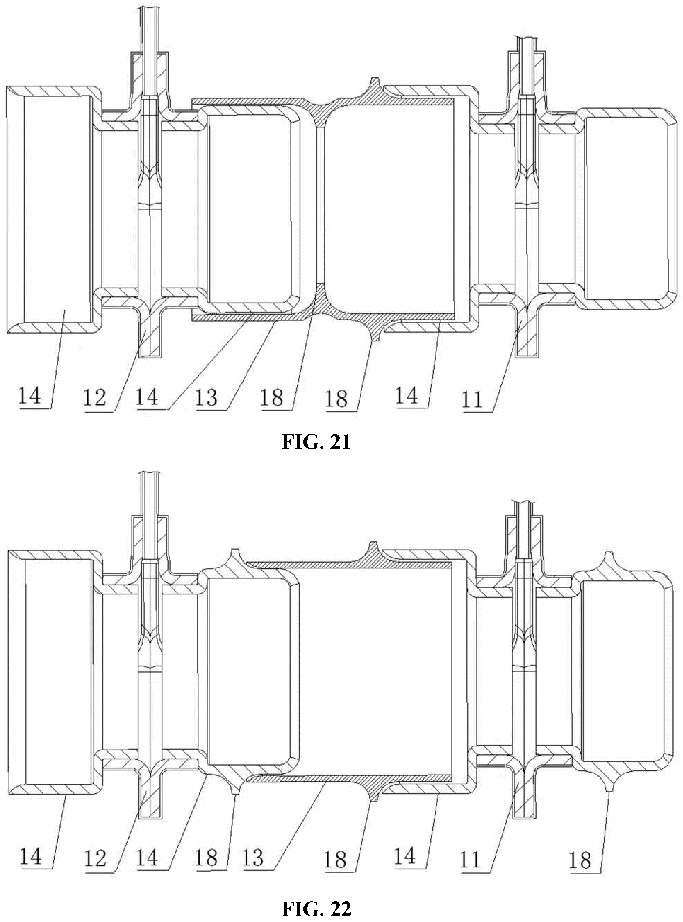

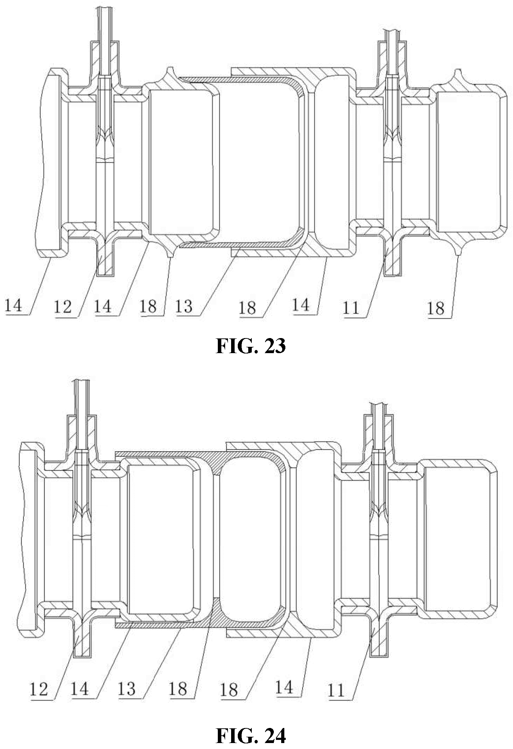

Certainly, as shown in FIG. 21, in the radial direction of the first connecting member 13, one end of the first connecting member 13 is located on the outer periphery of the first match part 14 of the second cooling plate 12, and the other end of the first connecting member 13 is located on the inner periphery of the first match part 14 of the first cooling plate 11. Two position-limiting parts 18 are fixedly connected to the first connecting member 13 and abut against the first match part 14 of the second cooling plate 12 and the first match part 14 of the first cooling plate 11, respectively. Or, as shown in FIG. 22, one position-limiting part 18 is fixedly connected to the first connecting member 13 and abuts against the first match part 14 of the first cooling plate 11, and the other position-limiting part 18 is fixedly connected to the first match part 14 of the second cooling plate 12 and abuts against the first connecting member 13. Or, as shown in FIG. 23, one position-limiting part 18 is fixedly connected to the first match part 14 of the second cooling plate 12, and the other position-limiting part 18 is fixedly connected to the first match part 14 of the first cooling plate 11. These two position-limiting parts 18 abut against the first connecting member 13, respectively. Or, as shown in FIG. 24, one position-limiting part 18 is fixedly connected to the first connecting member 13 and abuts against the first match part 14 of the second cooling plate 12, and the other position-limiting part 18 is fixedly connected to the first match part 14 of the first cooling plate 11 and abuts against the first connecting member 13.

### Embodiment 3

Embodiment 3 shown in FIG. 3 is based on the solution of the previous embodiment where the first connecting member 13 is located on the outer periphery of the first match part 14 and the position-limiting part 18 is fixedly connected to the first connecting member 13. Specifically, one position-limiting part 18 is provided. The first connecting member 13 includes a connecting portion 111, which includes a second section 138 and a first section 137. In an extension direction of the first connecting member 13, the second section 138 and the first section 137 are located on two sides of the position-limiting part 18, respectively. The second section 138 is configured to form a fluid-tight connection with the first match part 14 of the second cooling plate 12, and the first section 137 is configured to form a fluid-tight connection with the first match part 14 of the first cooling plate 11. In the extension direction of the first connecting member 13, the second section 138 and the first section 137 have the same length. In the extension direction of the first connecting member 13, the assembly length of the first match part 14 of the first cooling plate 11 and the connecting portion 111 is the same with that of the first match part 14 of the second cooling plate 12 and the connecting portion 111, which reduces the risk that the assembly length of one first match part 14 is relatively great and thus the assembly length of the other first match part 14 is relatively small, thereby enhancing the sealing of the first match part 14 and the first connecting member 13. Or, as shown in FIG. 6, multiple position-limiting parts 18 are provided, which divide the connecting portion 111 into multiple sections, including the second section 138 assembled with the first match part 14 of the second cooling plate 12 and the first section 137 assembled with the first match part 14 of the first cooling plate 11. In the extension direction of the first connecting member 13, the second section 138 and the first section 137 have the same lengths.

### Embodiment 4

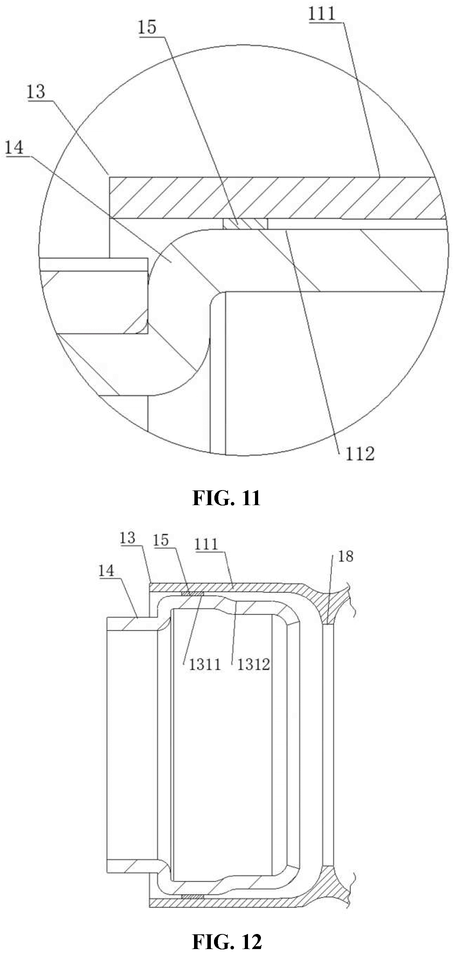

Embodiment 4 shown in FIG. 3 and FIG. 11 is based on the previous embodiment and specially discloses that the cooling plate assembly includes a first sealing part 15, and the first match part 14 includes a match portion 112. The first sealing part 15 is located between the connecting portion 111 and the match portion 112 and compressed therebetween. A fluid-tight connection between the first connecting member 13 and the first match part 14 is formed so as to prevent a fluid leakage, and the fluid-tight connection between the first connecting member 13 and the first match part 14 is achieved by the first sealing part 15.

### Embodiment 5

Reference is made to Embodiment 5 shown in FIG. 12, which is based on the previous embodiment and specifically discloses that the match portion 112 includes a large-diameter section 1311 and a small-diameter section 1312. The large-diameter section 1311 abuts against the first sealing part 15. In the assembly direction of the first match part 14 and the first connecting member 13, the small-diameter section 1312 is arranged closer to the position-limiting part 18 than the large-diameter section 1311. During assembly, in the radial direction of the first match part 14, the small-diameter section 1312 is arranged farther away from the first connecting member 13 than the large-diameter section 1311, which reduces the friction between the first sealing part 15 and the first match part 14 during assembly, thereby reducing the risk of deformation and damage caused by friction.

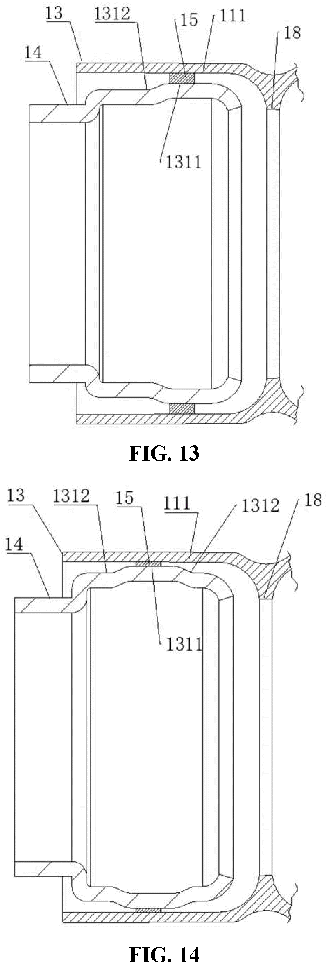

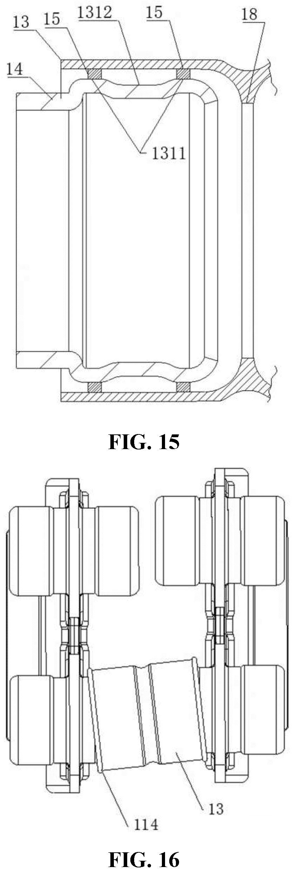

In this embodiment, in the assembly direction of the first match part 14 and the first connecting member 13, the small-diameter section 1312 is arranged closer to the position-limiting part 18 than the large-diameter section 1311. Or, as shown in FIG. 13, the large-diameter section 1311 is arranged closer to the position-limiting part 18 than the small-diameter section 1312. Or, as shown in FIG. 14, in the assembly direction of the first match part 14 and the first connecting member 13, two small-diameter sections 1312 are respectively provided on both sides of the large-diameter section 1311, or as shown in FIG. 15, in the assembly direction of the first match part 14 and the first connecting member 13, two large-diameter sections 1311 are respectively provided on both sides of the small-diameter section 1312, which reduce the friction between the first sealing part 15 and the first match part 14 during assembly. In addition, in the solution where the two large-diameter sections 1311 are provided on both sides of the small-diameter section 1312, the two large-diameter sections 1311 function of multi-stage sealing, which improves the sealing effect.

### Embodiment 6

Reference is made to Embodiment 6 shown in FIG. 16, which is based on the above embodiments and specifically discloses that the first connecting member 13 is formed by means of a double-shot molding process. The first connecting member 13 is made of polydodecylamine material, and the first sealing part 15 is made of thermoplastic elastomer material or liquid silicone material. After being formed by means of the double-shot molding process, the first connecting member 13 and the first sealing part 15 are fixedly connected by injection molding. After assembly, the first sealing part 15 is located on the outer periphery of the first match part 14, and the first connecting member 13 is located on the outer periphery of the first sealing part 15. Due to the fact that the first sealing part 15 is made of thermoplastic elastomer material or liquid silicone material, the sealing between the first connecting member 13 and the first match part 14 is achieved by the compression deformation of the thermoplastic elastomer material or liquid silicone material. The first connecting member 13 is made of polydodecylamine material, which provides a support stiffness and thus reduces the stretching for the first sealing part 15 and enhances the compression for the first sealing part 15, thereby improving the sealing performance. Moreover, due to the fact that the first sealing part 15 is located on the outer periphery of the first match part 14, when a positional difference is generated between two first match parts 14 and the first connecting member 13 in a direction perpendicular to the assembly direction of the first match part 14 and the first connecting member 13 after being assembled, the first connecting member 13 tilts and the sealing between the first sealing part 15 and the first match part 14 can be maintained, which improves the working stability.

The position-limiting part 18 has multiple connecting holes 1122. In the extension direction of the first connecting member 13, the connecting portions 111 on both ends of the position-limiting part 18 are in communication with each other through the connecting holes 1122. The first sealing parts 15 located on both ends of the position-limiting part 18 are connected through the connecting holes 1122. During injection molding, when forming the first sealing part 15 on one end of the position-limiting part 18 by injecting from this end, the first sealing part 15 on the other end of the position-limiting part 18 is also formed through the connecting holes 1122, which simplifies the injection molding process.

The first match part 14 is formed by means of a process of machining or cold heading.

### Embodiment 7

Reference is made to Embodiment 7 shown in FIG. 17, which is based on the above embodiments and specifically discloses that the first connecting member 13 includes reinforcing parts 114. In the extension direction of the first connecting member 13, the reinforcing parts 114 are located at both ends of the first connecting member 13, which increases the strength of the two ends of the first connecting member 13 and reduces the risk of cracking at both ends of the first connecting member 13 during assembly.

### Embodiment 8

Reference is made to Embodiment 8 shown in FIG. 17, which is based on the above embodiments and specifically discloses that a contact pressure between the first sealing part 15 and the match portion 112 is a first pressure, and a working pressure inside the first connecting member 13 is a second pressure. In the assembly direction of the first match part 14 and the first connecting member 13, an area where the first pressure is greater than the second pressure has a width not less than 1mm. In a circumferential direction of the first connecting member 13, a difference between the minimum and maximum values of the first pressure does not exceed 10%. It should be noted that the 10% means that the minimum value of the first pressure is not less than 90% of the maximum value of the first pressure, and the maximum value of the first pressure is not greater than 110% of the minimum value of the first pressure, which improves the sealing performance of the first connecting member 13 and the first match part 14 after assembly. In the direction perpendicular to the assembly direction of the first match part 14 and the first connecting member 13, the positional difference between the first match part 14 of the second cooling plate 12 and the first match part 14 of the first cooling plate 11 does not exceed 3mm, that is, the positional difference between the first match parts 14 installed on both sides of the first connecting member 13 does not exceed 3mm in the direction perpendicular to the assembly direction of the first match part 14 and the first connecting member 13, which reduces the risk of leakage between the first connecting member 13 and the first match part 14.

### Embodiment 9

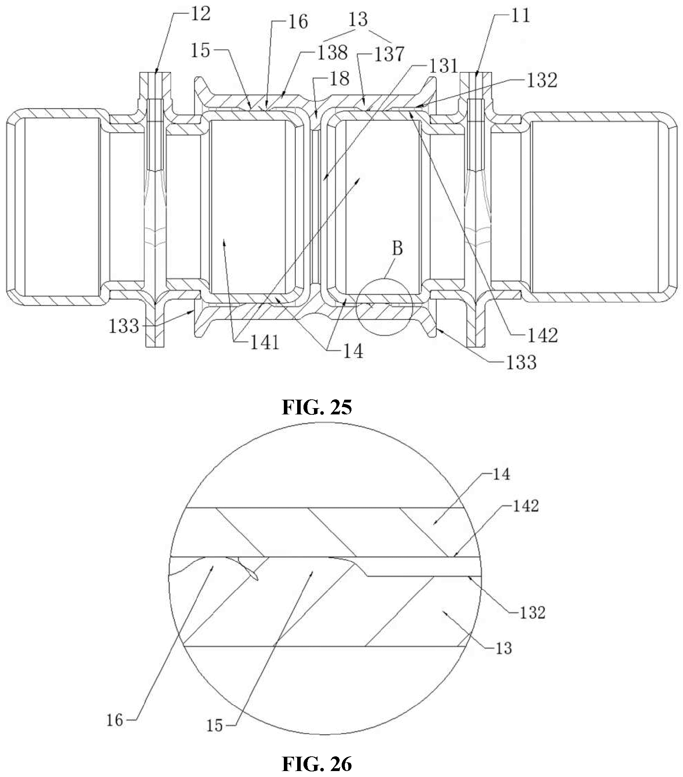

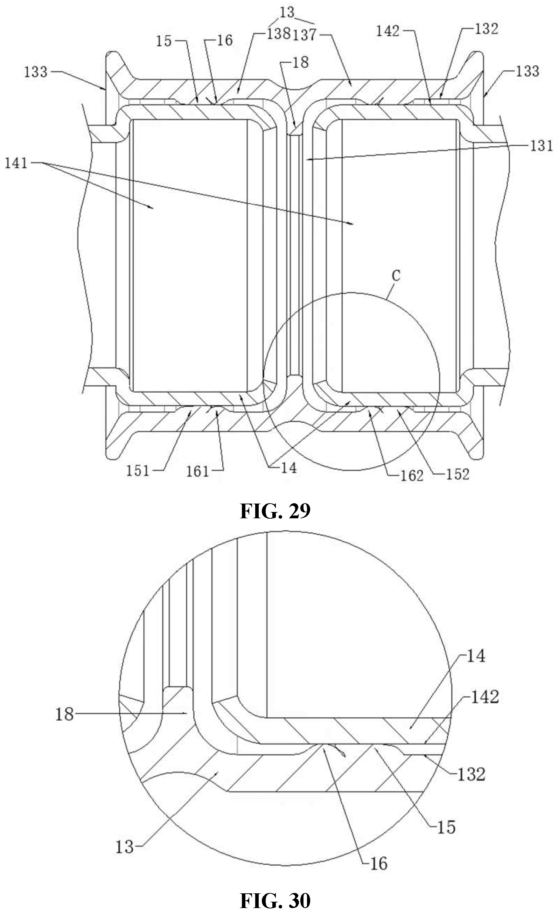

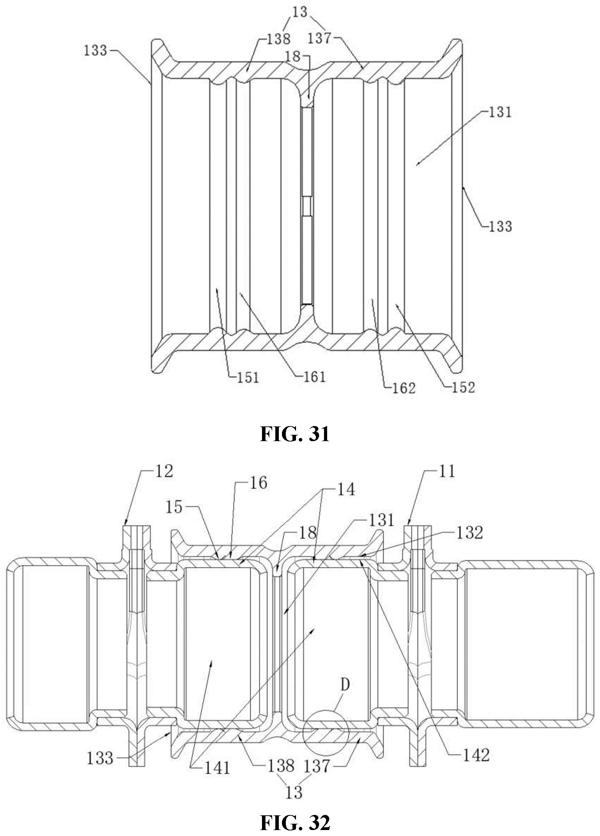

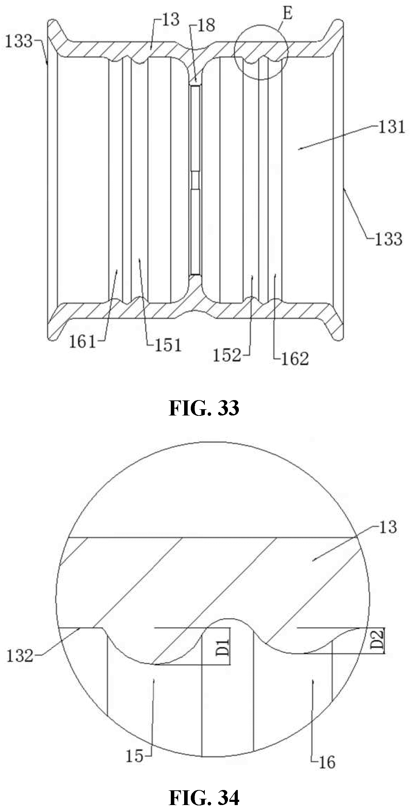

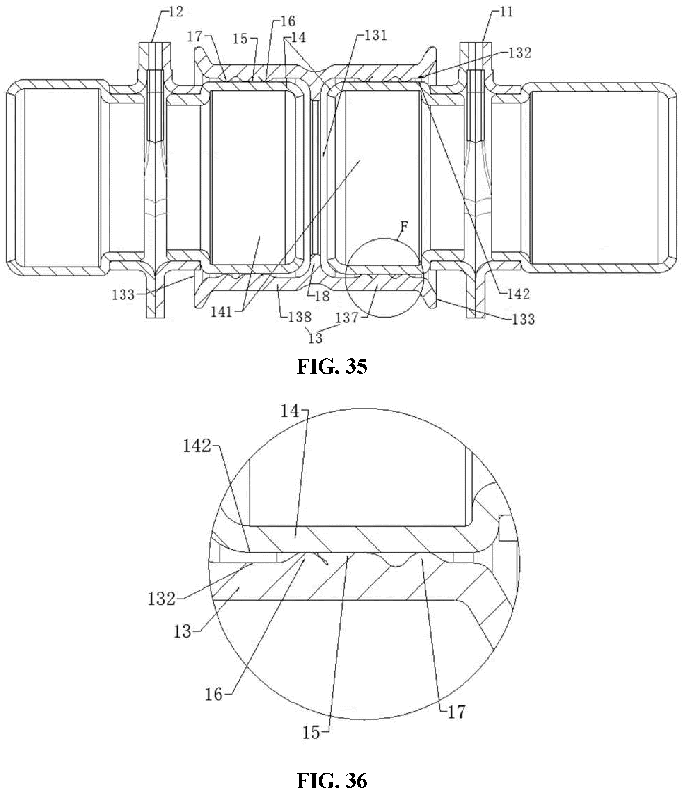

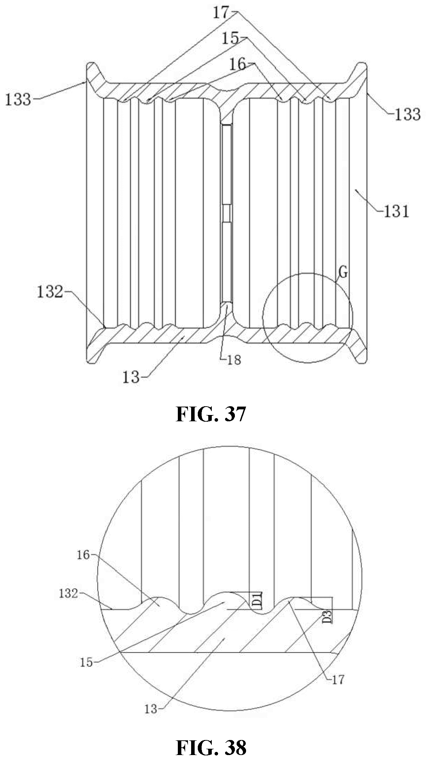

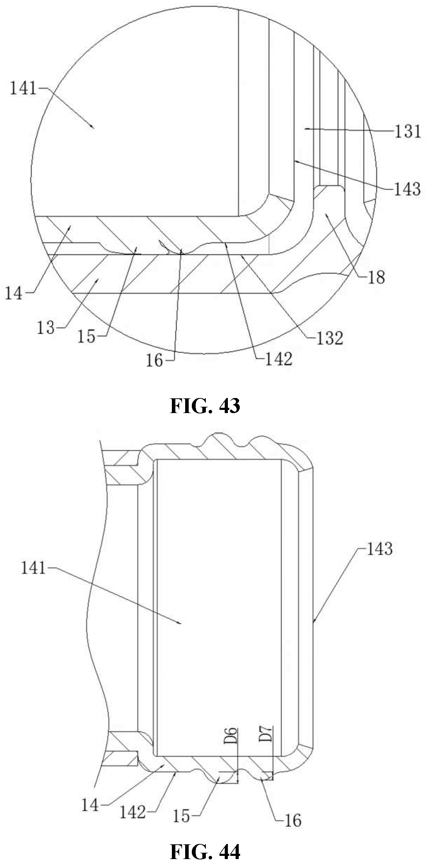

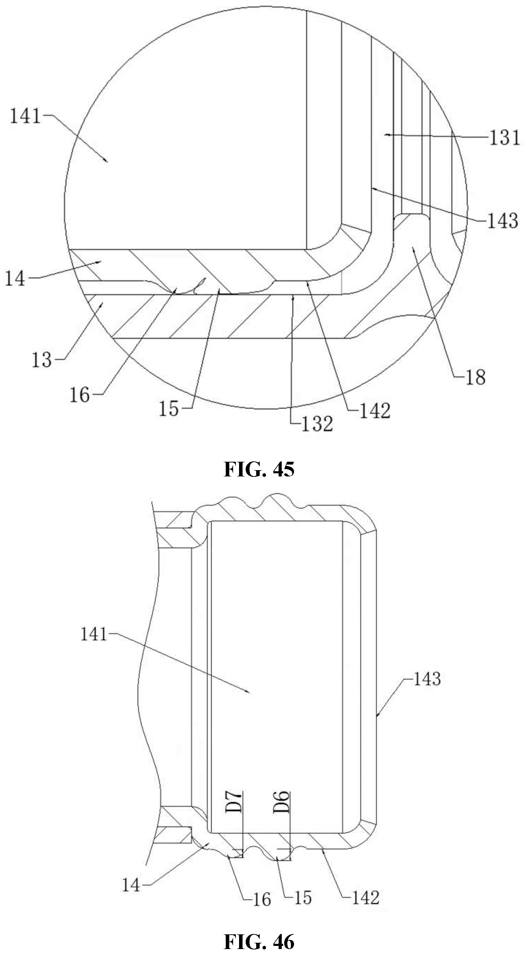

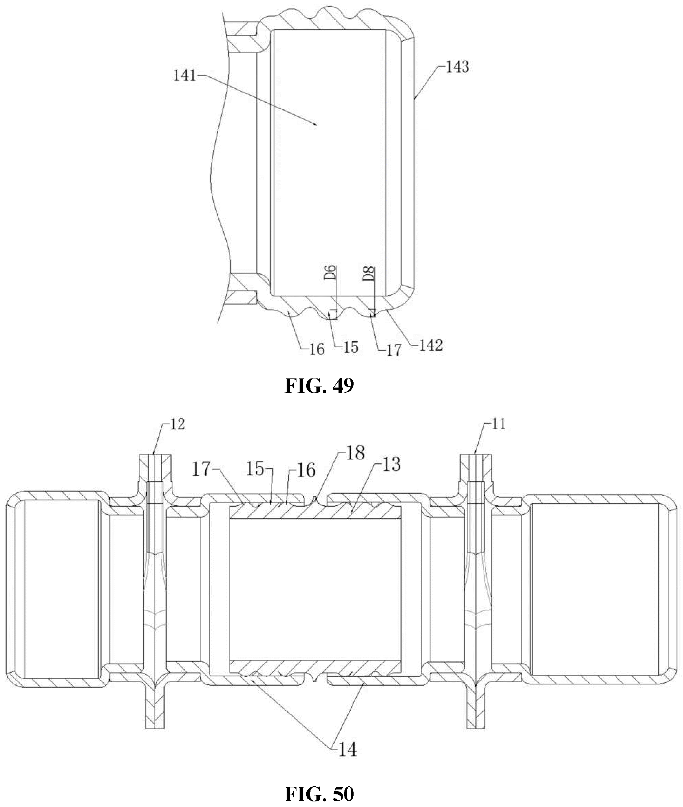

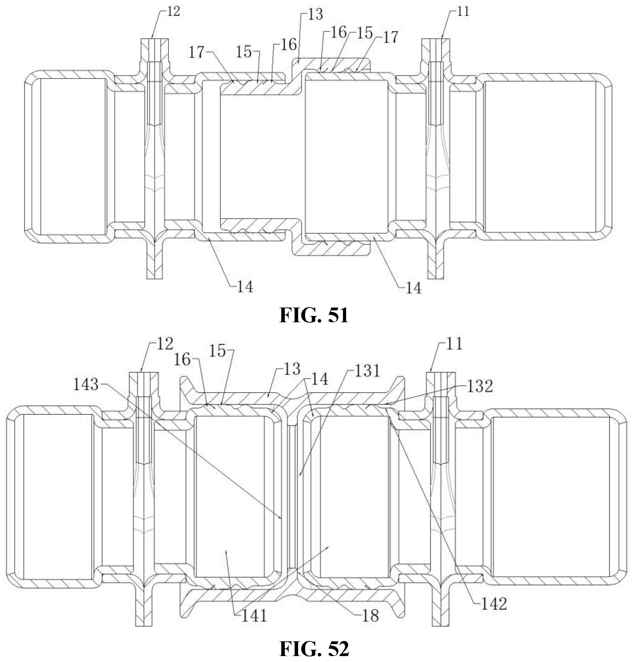

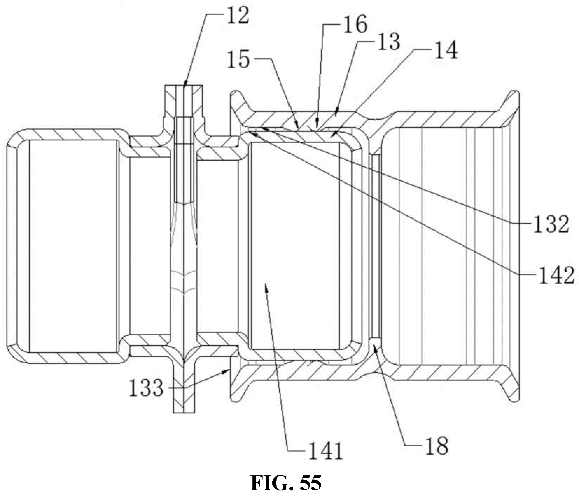

Reference is made to Embodiment 9 shown in FIG. 25 to FIG. 55. The present embodiment further discloses that the cooling plate assembly includes a first cooling plate 11, a second cooling plate 12, and a first connecting member 13. The first cooling plate 11 and the second cooling plate 12 each include a first match part 14. One first connecting member 13 is assembled with two first match parts 14. The first connecting member 13 has a first communication portion 131, and the first match part 14 has a second communication portion 141. The first communication portion 131 is in communication with the second communication portion 141, and the medium in the first cooling plate 11 flows to the second communication portion 141 in communication with the first cooling plate 11. Due to the assembly of the first connecting member 13 with the two first match parts 14, the medium in the first match part 14 in communication with the first cooling plate 11 flows into the first connecting member 13, then flows into the first match part 14 in communication with the second cooling plate 12, and then flows into the second cooling plate 12. In other embodiments, as shown in FIG. 55, the cooling plate assembly includes the second cooling plate 12 and the first connecting member 13. The second cooling plate 12 includes the first match part 14, and the first connecting member 13 is assembled with the first match part 14.

As shown in FIG. 25 to FIG. 55, the cooling plate assembly includes at least one first connecting member 13, at least one first match part 14, and at least one first sealing part 15. The first communication portion 131 is in communication with the second communication portion 141 and sealed by the first sealing part 15. In the radial direction of the first connecting member 13, for the inner circumferential surface and the outer circumferential surface of the first connecting member 13, a circumferential surface of the first connecting member 13 that is relatively close to the first match part 14 is defined as the first circumferential surface 132. In the radial direction of the first connecting member 13, for an inner circumferential surface and an outer circumferential surface of the first match part 14, the circumferential surface of the first match part 14 that is relatively close to the first connecting member 13 is defined as the second circumferential surface 142. The first circumferential surface 132 is sealedly connected with the first sealing part 15, and the second circumferential surface 142 is sealedly connected with the first sealing part 15, so that the sealing of the first communication portion 131 and the second communication portion 141 is achieved, and the fluid does not flow out of the cooling plate assembly. The cooling plate assembly includes a first ribbed part 16 connected to the first connecting member 13, and the first ribbed part 16 abuts against the first sealing part 15. Therefore, in the axial direction of the first connecting member 13, the maximum deformation of the first sealing part 15 is restricted by the first ribbed part 16, which reduces the risk of sealing failure caused by an excessive deformation of the first sealing part 15 and thus improves the sealing reliability of the first sealing part 15. In this embodiment, the first ribbed part 16 and the first connecting member 13 are integrally formed, and the maximum deformation of the first ribbed part 16 is limited, which reduces the risk of sealing failure caused by an excessive deformation of the first sealing part 15 and thus improves the sealing reliability of the first sealing part 15. Alternatively, the first ribbed part 16 and the first match part 14 may be integrally formed, or, the first ribbed part 16 is integrally formed with one of the first connecting member 13 and the first match part 14 and is sealedly connected to the other of the first connecting member 13 and the first match part 14. In other embodiments, a gap may be provided between the first ribbed part 16 and the first sealing part 15 in the axial direction of the first connecting member 13. It should be noted that in this embodiment, although, due to a small deformation of the first sealing part 15, the first sealing part 15 is not in contact with the first ribbed part 16, due to the existence of the gap between the first ribbed part 16 and the first sealing part 15 in the axial direction of the first connecting member 13, the first ribbed part 16 can limit the maximum deformation of the first sealing part 15 in the axial direction of the first connecting member 13, which reduces the risk of sealing failure caused by an excessive deformation of the first sealing part 15 and thus improves the sealing reliability of the first sealing part 15.

A method for manufacturing a cooling plate assembly is further provided, which includes manufacturing a first connecting member 13 and a first match part 14. The above steps include forming the first sealing part 15 and the first ribbed part 16 in at least one of the first connecting member 13 and the first match part 14, that is, the first sealing part 15 and the first ribbed part 16 may be formed in the first connecting member 13, or the first sealing part 15 and the first ribbed part 16 may be formed in the first match part 14. The first sealing part 15 is arranged closer to a central axis of the first connecting member 13 than the first ribbed part 16, and the first sealing part 15 and the first ribbed part 16 are spaced in the axial direction of the first connecting member 13. The above steps further include assembling the first connecting member 13 and the first match part 14.

The first connecting member 13 and the first match part 14 are assembled. The first sealing part 15 is arranged closer to the central axis of the first connecting member 13 than the first ribbed part 16, which reduces the friction between the first ribbed part 16 and the first connecting member 13 or the first match part 14.

Furthermore, the compression ratio of the first sealing part 15 is set between 15% and 55%. If the compression ratio is too high, it will cause excessive deformation of the first sealing part 15, leading to a decrease of sealing reliability. Therefore, the compression ratio of the first sealing part 15 is set between 15% and 55%, which reduces the risk of the decreasing of the sealing reliability.

### Embodiment 10

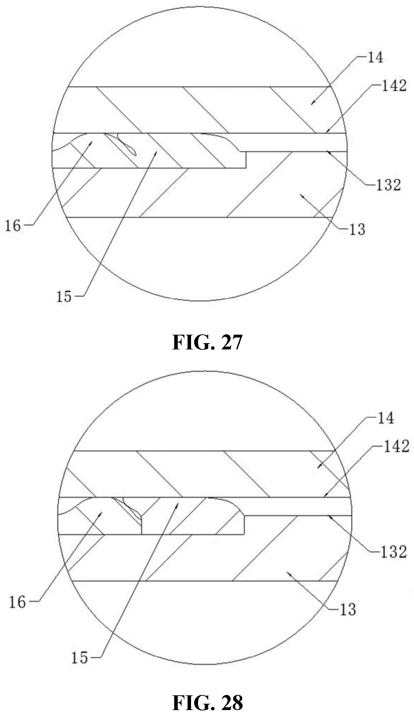

Reference is made to Embodiment 10 shown in FIG. 25, FIG. 27, FIG. 28, and FIG. 32 to FIG. 34, which is based on Embodiment 9 and specifically discloses that the first sealing part 15 is connected to the first connecting member 13 and the first ribbed part 16 is connected to the first connecting member 13. It should be noted that, in this embodiment, the first sealing part 15 and the first connecting member 13 are integrally formed, and the first ribbed part 16 and the first connecting member 13 are integrally formed, which achieves the connection of the first sealing part 15 and the first connecting member 13 and the connection of the first ribbed part 16 and the first connecting member 13. In other embodiments, as shown in FIG. 27 and FIG. 28, the first sealing part 15 and the first ribbed part 16 may be integrally formed, and the integral structure of the first sealing part 15 and the first ribbed part 16 and the first connecting member 13 are separately formed. Or, all the first sealing part 15, the first ribbed part 16 and the first connecting member 13 are separately formed, and the first sealing part 15 is in a tight contact with the first circumferential surface 132 of the first connecting member 13 for sealing, and the first sealing part 15 is in a tight contact with the second circumferential surface 142 of the first match part 14 for sealing. In the axial direction of the first connecting member 13, the first connecting member 13 has a first end portion 133, and the first sealing part 15 is arranged closer to the first end portion 133 than the first ribbed part 16. In the radial direction of the first connecting member 13, the first connecting member 13 is located on the outer periphery of the first match part 14. Both the first sealing part 15 and the first ribbed part 16 protrude out of the first circumferential surface 132. Due to the protrusion of the first sealing part 15 out of the first circumferential surface 132, when the first connecting member 13 and the first match part 14 are assembled, the first sealing part 15 is displaced and deformed under the action of the friction between the first sealing part 15 and the match part 14. In that case, the protruding structure of the first ribbed part 16 out of the first circumferential surface 132 can limit the maximum deformation of the first sealing part 15 in the axial direction of the first connecting member 13, which reduces the risk of sealing failure caused by excessive deformation of the first sealing part 15 and thus improves the sealing reliability of the first sealing part 15. In this embodiment, the first connecting member 13 includes a first section 137 and a second section 138. The first section 137 is assembled with the first match part 14 of the first cooling plate 11, and the second section 138 is assembled with the first match part 14 of the second cooling plate 12. The first connecting member 13 includes two first end portions 133, which are located in the first section 137 and the second section 138, respectively. The first sealing part 15 includes a first sub sealing part 151 and a second sub sealing part 152, and the first ribbed part 16 includes a first sub ribbed part 161 and a second sub ribbed part 162. The second sub sealing part 152 and the first section 137 are integrally formed, and the second sub ribbed part 162 and the first section portion 137 are integrally formed. The first sub sealing part 151 and the second section portion 138 are integrally formed, and the first sub ribbed part 161 and the second section portion 138 are integrally formed. In the axial direction of the first connecting member 13, the first sub sealing part 151 is arranged closer to the second cooling plate 12 than the first sub ribbed part 161, and the second sub sealing part 152 is arranged closer to the first cooling plate 11 relative to the second sub ribbed part 162. The first sub sealing part 151 abuts against the first sub ribbed part 161, and the second sub sealing part 152 abuts against the second sub ribbed part 162. The maximum deformation of the first sub sealing part 151 is restricted by the first sub ribbed part 161, and the deformation of the second sub ribbed part 162 is restricted by the second sub ribbed part 162, which reduces the risk of sealing failure caused by excessive deformation of the first sub sealing part 151 and the second sub ribbed part 162 and thus improves the sealing reliability of the first sub sealing part 151 and the second sub ribbed part 162. It should be noted that, in this embodiment, the first connecting member 13 is assembled with two first match parts 14, and the first connecting member 13 includes two first end portions 133. Therefore, in this embodiment, for the expression that the first sealing part 15 is arranged closer to the first end portion 133 relative to the first ribbed part 16 or the expression that the first ribbed part 16 is arranged closer to the first end portion 133 than the first sealing part 15, the first sealing part 15 and the first ribbed part 16 herein refer to the first sub sealing part 151 and the first sub ribbed part 161 or the second sub sealing part 152 and the second sub ribbed part 162. That is, when the first sealing part 15 represents for the first sub sealing part 151, the first ribbed part 16 represents for the first sub ribbed part 161. When the first sealing part 15 represents for the second sub sealing part 152, the first ribbed part 16 represents for the second sub ribbed part 162. Due to the protrusion of the first sealing part 15 out of the first circumferential surface 132, the first sealing part 15 is connected to the second circumferential surface 142, and thus the first sealing part 15 and the second circumferential surface 142 form sealing. Therefore, the resistance for assembling the first connecting member 13 and the first match part 14 includes the friction between the first sealing part 15 and the second circumferential surface 142. Compared to the solution where the first circumferential surface 132 and the second circumferential surface 142 are in contact and thus form sealing, the contact area with the second circumferential surface 142 is reduced by replacing the first circumferential surface 132 with the first sealing part 15 to be sealed with the second circumferential surface 142, which reduces the resistance for assembling the first connecting member 13 and the first match part 14 and lowers the deformation risk during the assembly of the first connecting member 13 and the first match part 14, since a contact area between the first sealing part 15 and the second circumferential surface 142 is smaller than that between the first circumferential surface 132 and the second circumferential surface 142.

For the method of manufacturing the cooling plate assembly, before assembling the first connecting member 13 and the first match part 14, in the radial direction of the first connecting member 13, the protruding distance of the first sealing part 15 out of the first circumferential surface 132 is a first distance D1, and the protruding distance of the first ribbed part 16 out of the first circumferential surface 132 is a second distance D2. The first distance D1 is greater than the second distance D2. Due to the protruding distance of the first ribbed part 16 being less than that of the first sealing part 15, the friction between the first ribbed part 16 and the second circumferential surface 142 is reduced, which reduces the resistance for assembling first connecting member 13 and the first match part 14. Further, since the first ribbed part 16 protrudes out of the first circumferential surface 132, the first ribbed part 16 implements the function of guiding the first match part 14, which reduces the risk of the first circumferential surface 132 to be torn by an excessive local interference due to the positional deviation during assembly of the first match part 14 and the first connecting member 13.

### Embodiment 11

Reference is made to Embodiment 11 shown in FIG. 25 to FIG. 31. The difference between this embodiment and Embodiment 10 is in that, in the axial direction of the first connecting member 13, the first ribbed part 16 is arranged closer to the first end portion 133 than the first sealing part 15, and the first sealing part 15 and the first ribbed part 16 protrude out of the first circumferential surface 132. Due to the protrusion of the first sealing part 15 out of the first circumferential surface 132, when the first connecting member 13 and the first match part 14 are assembled, the first sealing part 15 is displaced and deformed under the action of the friction between the first sealing part 15 and the first match part 14, and thus the first ribbed part 16 protrudes out of the first circumferential surface 132. In the axial direction of the first connecting member 13, the maximum deformation of the first sealing part 15 is restricted by the first ribbed part 16, which reduces the risk of sealing failure caused by excessive deformation of the first sealing part 15 and thus improves the sealing reliability of the first sealing part 15, In this embodiment, in the axial direction of the first connecting member 13, the first sub ribbed part 161 is arranged closer to the second cooling plate 12 than the first sub sealing part 151, and the second sub ribbed part 162 is arranged closer to the first cooling plate 11 than the second sub sealing part 152. The first sub sealing part 151 abuts against the first sub ribbed part 161, and the second sub sealing part 152 abuts against the second sub ribbed part 162. The maximum deformation of the first sub sealing part 151 is restricted by the first sub ribbed part 161, and the maximum deformation of the second sub sealing part 152 is restricted by the second sub ribbed part 162, which reduces the risk of sealing failure caused by excessive deformation of the first sub sealing part 151 and the second sub ribbed part 162, and thus improves the sealing reliability of the first sub sealing part 151 and the second sub ribbed part 162.

For the method of manufacturing the cooling plate assembly, before assembling the first connecting member 13 and the first match part 14, in the radial direction of the first connecting member 13, the protruding distance of the first sealing part 15 out of the first circumferential surface 132 is a first distance D1, and the protruding distance of the first ribbed part 16 out of the first circumferential surface 132 is a second distance D2. The first distance D1 is not less than the second distance D2. Since the protruding distance of the first sealing part 15 is not less than that of the first ribbed part 16, the friction between the first ribbed part 16 and the second circumferential surface 142 is reduced, which reduces the resistance applying to the first connecting member 13 and the first match part 14 during assembling the first connecting member 13 and the first match part 14. Because the first connecting member 13 is assembled with the first match part 14, the first sealing part 15 is displaced and deformed in the direction of the first end portion 133 towards a center line 134, and thus the resistant capacity of the first sealing part 15 withstanding a negative pressure is lowered. It should be noted that the negative pressure refers to a situation where the pressure of the fluid is lower than the external atmospheric pressure when the fluid flows inside the first communication portion 131 and the second communication portion 141, and, in that case, a pressure, generated by the external atmospheric pressure applying to the sealing part, i.e., at the first sealing part 15, of the connecting part 13 and the first match part 14, is the negative pressure. The direction of the negative pressure is the direction of the first end portion 133 towards the center line 134. Since the first sealing part 15 can be supported by the first ribbed part 16, the first ribbed part 16 increases the resistant capacity of the first sealing part 15 against the negative pressure, which provides a sealing reliability of the first sealing part 15.

### Embodiment 12

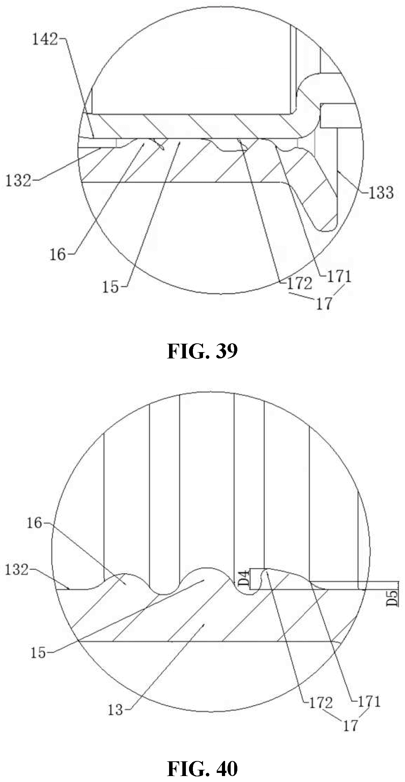

Reference is made to Embodiment 12 shown in FG. 35 to FIG. 40, which is based on Embodiment 9 and specifically discloses that the cooling plate assembly includes a second ribbed part 17 connected to the first connecting member 13. It should be noted that, in this embodiment, the second ribbed part 17 and the first connecting member 13 are integrally formed, which achieves the connection of the second ribbed part 17 and the first connecting member 13. In other embodiments, the second ribbed part 17, the first ribbed part 16, and the first sealing part 15 may be integrally formed, and the first connecting member 13 and the integral structure of the second ribbed part 17, the first ribbed part 16, and the first sealing part 15 are separately formed. The second ribbed part 17 protrudes out of the first circumferential surface 132. In the axial direction of the first connecting member 13, the second ribbed part 17 is located on one side of the first sealing part 15, and the first ribbed part 16 is located on the other side of the first sealing part 15. Since the second ribbed part 17 protrudes relative to the first circumferential surface 132, the first sealing part 15 is arranged closer to the first end portion 133 than the first ribbed part 16, and the second ribbed part 17 is located on the other side of the first sealing part 15, and thus the second ribbed part 17 is arranged closer to the first end portion 133 than the first sealing part 15. The second ribbed part 17 implements a function of guiding the first match part 14, which reduces the risk of the first circumferential surface 132 to be torn by an excessive local interference due to the positional deviation during assembly of the first match part 14 and the first connecting member 13.

For the method of manufacturing the cooling plate assembly, before assembling the first connecting member 13 and the first match part 14, the protruding distance of the second ribbed part 17 out of the first circumferential surface 132 in the radial direction of the first connecting member 13 is a third distance D3, which is less than the first distance D1. Due to the protruding distance of the second ribbed part 17 being less than that of the first sealing part 15, the friction between the second ribbed part 17 and the second circumferential surface 142 is reduced, which reduces the resistance for assembling the first connecting member 13 and the first match part 14.

Furthermore, the second ribbed part 17 is connected to the second circumferential surface 142. Since the second ribbed part 17 is arranged closer to the first end portion 133 than the first sealing part 15, and the second ribbed part 17 is connected to the second circumferential surface 142, the first sealing part 15 is covered by the second ribbed part 17, which reduces the risk of impurities entering the first sealing part 15 and thus improves the sealing reliability of the first sealing part 15.

For the method of manufacturing the cooling plate assembly, before assembling the first connecting member 13 and the first match part 14, in the axial direction of the first connecting member 13, one end of the second ribbed part 17 close to the first end portion 133 is defined as a first sub part 171, and the second ribbed part 17 includes a second sub part 172. Before assembling the first connecting member 13 and the first match part 14, in the radial direction of the first connecting member 13, the protruding distance of the first sub part 171 out of the first circumferential surface 132 is a fourth distance D4, and the protruding distance of the second sub part 172 out of the first circumferential surface 132 is a fifth distance D5. The fourth distance D4 is less than the fifth distance D5, that is, the protruding distance of a part of the second ribbed part 17 close to the first end portion 133 out of the first circumferential surface 132 is small, which improves the guiding effect of the second reinforcement part 17 on the first match part 14.

### Embodiment 13

Reference is made to Embodiment 13 shown in FIG. 25, FIG. 27, FIG. 28, and FIG. 41 to FIG. 44. The difference between this embodiment and Embodiment 9 is in that the first sealing part 15 is connected to the first match part 14, and the first ribbed part 16 is connected to the first match part 14. It should be noted that, in this embodiment, the first sealing part 15 and the first match part 14 are integrally formed, and the first ribbed part 16 and the first match part 14 are integrally formed, which achieves the connection of the first sealing part 15 and the first match part 14 and the connection of the first ribbed part 16 and the first match part 14. In other embodiments, the first sealing part 15 and the first ribbed part 16 may be integrally formed, and the first match part 14 and the integral structure of the first sealing part 15 and the first ribbed part 16 are separately formed, which achieves the sealing formed by the first sealing part 15 and the first circumferential surface 132 of the first connecting member 13 and the sealing formed by the first sealing part 15 and the second circumferential surface 142 of the first match part 14. In the axial direction of the first connecting member 13 and the axial direction of the first match part 14, a second end portion 143 is defined as the end of the first match part 14 that is relatively close to the first connecting member 13. In the axial direction of the first match part 14, the first ribbed part 16 is arranged closer to the second end portion 143 than the first sealing part 15. In the radial direction of the first match part 14, the first match part 14 is located on the inner periphery of the first connecting member 13. In the radial direction of the first match part 14, the first sealing part 15 and the first ribbed part 16 protrude out of the second circumferential surface 142. Due to the protrusion of the first sealing part 15 out of the second circumferential surface 142, when the first connecting member 13 and the first match part 14 are assembled, the first sealing part 15 is displaced and deformed under the action of friction between the first sealing part 15 and the first connecting member 13. Therefore, the first ribbed part 16 protrudes out of the second circumferential surface 142, and the maximum deformation of the first sealing part 15 can be restricted by the first ribbed part 16, which reduces the risk of sealing failure caused by excessive deformation of the first sealing part 15 and thus improves the sealing reliability of the first sealing part 15. Due to the protrusion of the first sealing part 15 out of the second circumferential surface 142, the first sealing part 15 is connected to the first circumferential surface 132, and thus the first sealing part 15 forms sealing with the first circumferential surface 132. Therefore, the resistance for assembling the first connecting member 13 and the first match part 14 includes the friction between the first sealing part 15 and the first circumferential surface 132. Compared to the solution where the first circumferential surface 132 and the second circumferential surface 142 are in contact and thus sealed, the contact area with the first circumferential surface 132 is reduced by replacing the second circumferential surface 142 with the first sealing part 15 to be sealed with the first circumferential surface 132, which reduces the resistance for assembling the first connecting member 13 and the first match part 14 and lowers the deformation risk during the assembly of the first connecting member 13 and the first match part 14, since a contact area between the first sealing part 15 and the first circumferential surface 132 is smaller than that between the first circumferential surface 132 and the second circumferential surface 142.

For the method of manufacturing the cooling plate assembly, before assembling the first connecting member 13 and the first match part 14, in the radial direction of the first match part 14, the protruding distance of the first sealing part 15 out of the second circumferential surface 142 is a sixth distance D6, and the protruding distance of the first ribbed part 16 out of the second circumferential surface 142 is a seventh distance D7. The sixth distance D6 is greater than the seventh distance D7. Due to the protruding distance of the first ribbed part 16 being lower than that of the first sealing part 15, the friction between the first ribbed part 16 and the first circumferential surface 132 is reduced, which reduces the resistance for assembling the first connecting member 13 and the first match part 14. Further, due to the protrusion of the first ribbed part 16, the first ribbed part 16 implements a function of guiding the first match part 14, which reduces the risk of the second circumferential surface 142 to be torn by the excessive local interference caused by the positional deviation during assembly of the first match part 14 and the first connecting member 13.

### Embodiment 14

Reference is made to Embodiment 14 shown in FIG. 25, FIG. 27, FIG. 28, FIG. 41, FIG. 42, FIG. 45, and FIG. 46. The difference between this embodiment and Embodiment 13 is in that, in the axial direction of the first match part 14, the first sealing part 15 is arranged closer to the second end portion 143 than the first ribbed part 16, and in the radial direction of the first match part 14, the first sealing part 15 and the first ribbed part 16 protrude out of the second circumferential surface 142. Due to the protrusion of the first sealing part 15 out of the second circumferential surface 142, when the first connecting member 13 and the first match part 14 are assembled, the first sealing part 15 is displaced and deformed under the action of friction between the first sealing part 15 and the first connecting member 13. Therefore, the first ribbed part 16 protrudes out of the second circumferential surface 142, and the maximum deformation of the first sealing part 15 can be restricted by the first ribbed part 16, which reduces the risk of sealing failure caused by excessive deformation of the first sealing part 15 and thus improves the sealing reliability of the first sealing part 15. Before assembling the first connecting member 13 and the first match part 14, in the radial direction of the first match part 14, the protruding distance of the first sealing part 15 out of the second circumferential surface 142 is a sixth distance D6, and the protruding distance of the first ribbed part 16 out of the second circumferential surface 142 is a seventh distance D7. The sixth distance D6 is not less than the seventh distance D7. Since the protruding distance of the first sealing part 15 is not less than that of the first ribbed part 16, the friction between the first ribbed part 16 and the second circumferential surface 142 is reduced, which reduces the resistance for assembling the first connecting member 13 and the first match part 14. Because the first connecting member 13 is assembled with the first match part 14, the first sealing part 15 is deformed in the axial direction of the first match part 14, and thus the resistant capacity of the first sealing part 15 withstanding a negative pressure is lowered. It should be noted that the negative pressure refers to the situation where the pressure of the fluid is lower than the external atmospheric pressure when the fluid flows inside the first communication portion 131 and the second communication portion 141, and, in that case, a pressure, generated by the external atmospheric pressure applying to the sealing part, i.e., at the first sealing part 15, of the connecting part 13 and the first match part 14, is the negative pressure. The maximum deformation of the first sealing part 15 can be restricted by the first ribbed part 16, which reduces the risk of sealing failure caused by excessive deformation of the first sealing part 15 and thus increases the resistant capacity of the first sealing part 15 on the negative pressure, thereby improving the sealing reliability of the first sealing part 15.

### Embodiment 15

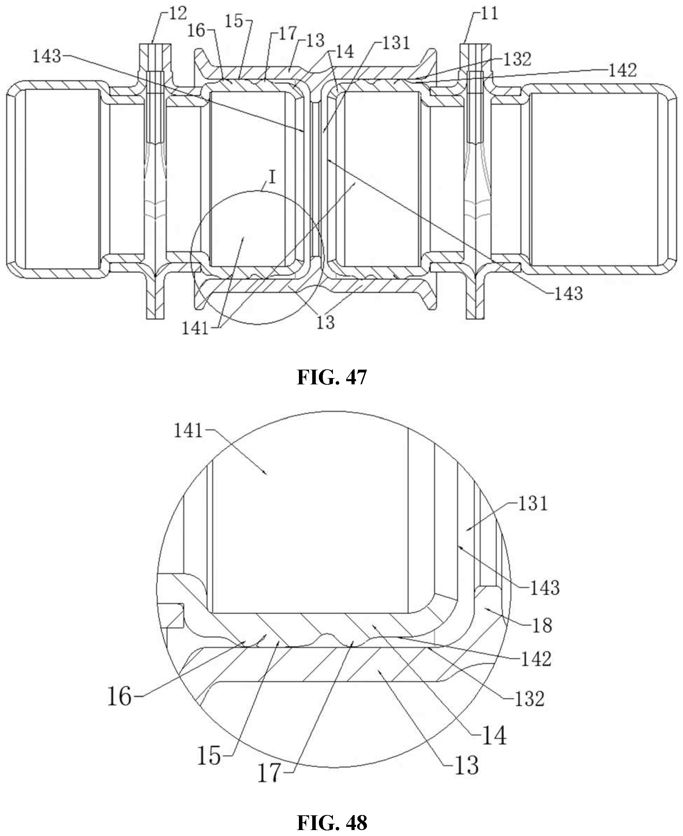

Reference is made to Embodiment 15 shown in FIG. 47 to FIG. 49, which is based on the previous embodiment and specifically discloses that the cooling plate assembly includes a second ribbed part 17, which is connected to a first match part 14. It should be noted, that in this embodiment, the second ribbed part 17 and the first match part 14 are integrally formed, which achieves the connection of the second ribbed part 17 and the first match part 14. In other embodiments, the second ribbed part 17, the first ribbed part 16, and the first sealing part 15 may be integrally formed, and the first match part 14 and the integral structure of the second ribbed part 17, the first ribbed part 16, and the first sealing part 15 are separately formed. The second ribbed part 17 protrudes out of the second circumferential surface 142. In the axial direction of the first match part 14, the second ribbed part 17 is located on one side of the first sealing part 15, and the first ribbed part 16 is located on the other side of the first sealing part 15. Due to the fact that the second ribbed part 17 protrudes out of the second circumferential surface 142, the first sealing part 15 is arranged closer to the second end portion 143 than the first ribbed part 16, and the second ribbed part 17 is located on the other side of the first sealing part 15, and thus the second ribbed part 17 is arranged closer to the second end portion 143 than the first sealing part 15. The second ribbed part 17 implements a function of guiding the first match part 14, which reduces the risk of the second circumferential surface 142 to be torn by an excessive local interference due to the positional deviation during assembly of the first match part 14 and the first connecting member 13. Before assembling the first connecting member 13 and the first match part 14, in the radial direction of the first match part 14, the protruding distance of the second ribbed part 17 out of the second circumferential surface 142 is an eighth distance D8, which is less than the sixth distance D6. Since the protruding distance of the second ribbed part 17 is less than that of the first sealing part 15, the friction between the second ribbed part 17 and the second circumferential surface 142 is reduced, which reduces the resistance for assembling the first connecting member 13 and the first match part 14.

Furthermore, the second ribbed part 17 is connected to the first circumferential surface 132. Since the second ribbed part 17 is arranged closer to the second end portion 143 than the first sealing part 15, and the second ribbed part 17 is connected to the first circumferential surface 132, the first sealing part 15 is covered by the second ribbed part 17, which reduces the risk of impurities entering the first sealing part 15 and thus improves the sealing reliability of the first sealing part 15.

### Embodiment 16

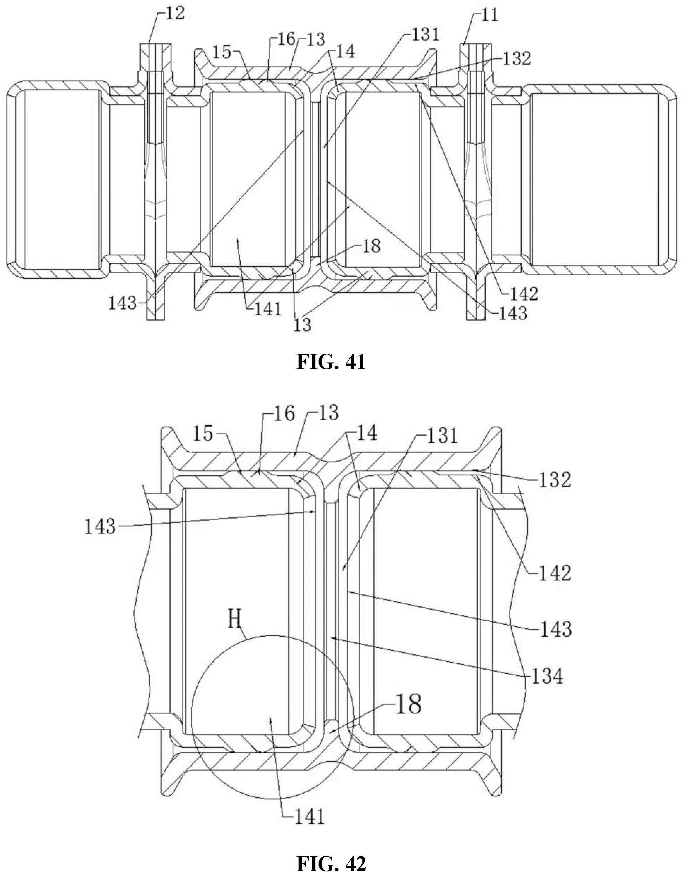

Reference is made to Embodiment 16 shown in FIG. 40 and FIG. 41. The difference between this embodiment and the above embodiments is in that, in the radial direction of the first connecting member 13, the first connecting member 13 is located on the inner periphery of the first match part 14. Certainly, the first connecting member 13 may be located on the outer periphery of one first match part 14 while on the inner periphery of another first match part 14 in the radial direction of the first connecting member 13.

### Embodiment 17

Reference is made to Embodiment 17 shown in FIG. 42, which is based on the above embodiments and specifically discloses that the cooling plate assembly includes a position-limiting part 18. The position-limiting part 18 is connected to the first connecting member 13 in the radial direction of the first connecting member 13. The first match part 14 has a second end portion 143 in the axial direction of the first match part 14. In the axial direction of the first match part 14, the second end portion 143 is defined as an end of the first match part 14 that is relatively close to the first connecting member 13. On a plane perpendicular to the axial direction of the first connecting member 13, an orthographic projection of the position-limiting part 18 on this plane at least partially overlaps with an orthographic projection of the second end portion 143 on the plane. Due to the fact that the orthographic projection of the position-limiting part 18 on the plane at least partially overlaps with the orthographic projection of the second end portion 143 on the plane, when assembling the first connecting member 13 and the first match part 14, in the assembly direction of the first connecting member 13 and the first match part 14, the position-limiting part 18 functions as a stop for the first match part 14, which restricts the relative movement of the first connecting member 13 and the first match part 14. The position-limiting part 18 functions as a stop during the assembly, so as to limit the maximum length of an assembling part of the first connecting member 13 and the first match part 14, and thus the position-limiting part 18 implements a position-limiting function, which reduces the installation difficulty.

### Embodiment 18

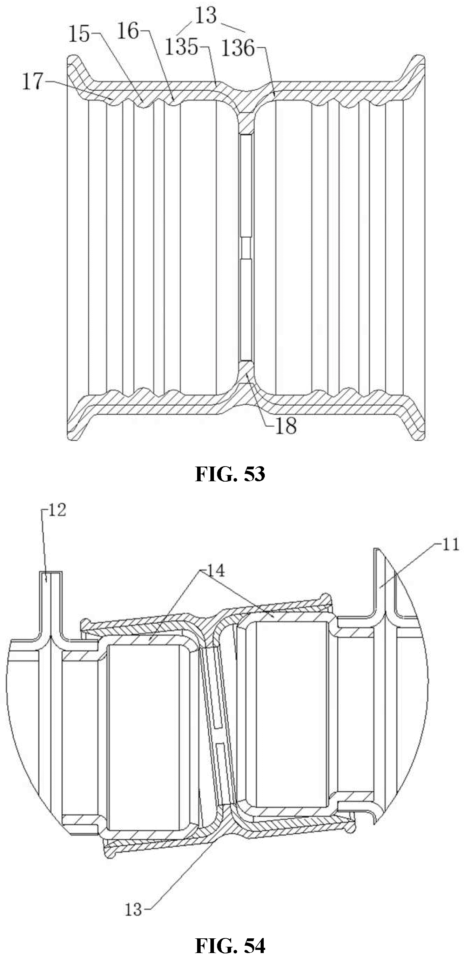

Reference is made to Embodiment 18 shown in FIG. 53 to FIG. 55, which is based on the above embodiments and specifically discloses that the first connecting member 13 is formed by means of a double-shot molding process. The first connecting member 13 includes a first layer part 135 and a second layer part 136. The first layer part 135 is made of plastic material, and the second layer part 136 is made of elastic material. In this embodiment, the first layer part 135 is made of rigid PA12 plastic, and the second layer part 136 is made of thermoplastic elastomer material or liquid silicone material. The first layer part 135 is fixedly connected to the second layer part 136. By means of a double-shot molding process, the first layer part 135 and the second layer part 136 are fixedly connected by injection molding. When the first connecting member 13 is assembled with the first match part 14, due to the fact that the second layer part 136 is made of thermoplastic elastomer material or liquid silicone material, the sealing formed by the first connecting member 13 and the first match part 14 is achieved by the compression deformation of the thermoplastic elastomer material or liquid silicone material. The first layer part 135 is made of rigid PA12 plastic, which provides a support stiffness and thus reduce the stretching for the first sealing rib and enhances the compression for the first sealing rib, thereby improving the sealing performance. Moreover, since the first layer part 135 is located on the outer periphery of the second layer part 136, when a positional deviation is generated in the assembly direction of the first connecting member 13 and the first match parts 14 after the two first match parts 14 are assembled with the first connecting member 13, the first connecting member tilts, the sealing formed by the first sealing rib and the first match part 14 can be maintained, which improves the sealing reliability.

### Embodiment 19

Reference is made to Embodiment 19 shown in FIG. 25 to FIG. 55, which is based on the above embodiments and specifically discloses that a contact pressure between the first sealing part 15 and the first match part 14 or the first connecting member 13 is a first pressure, and a working pressure inside the first connecting member 13 is a second pressure. In the axial direction of the first connecting member 13, the area where the first pressure is greater than the second pressure has a width not less than 0.6mm. In the direction perpendicular to the axial direction of the first connecting member 13, the positional difference between an axis of the first connecting member 13 and an axis of the first match part 14 is not greater than 3mm. After the first connecting member 13 is assembled with the first match part 14, the compression rate of the first sealing part 15 is between 15% and 55%, which reduces the risk of sealing failure between the first connecting member 13 and the first match part 14, thereby improving the sealing reliability. The second layer part 136 has a Shore A hardness, which is between 40 and 65. Since the first sealing part 15 and the first ribbed part 16 are arranged to protrude, it is difficult during demolding. The Shore A hardness of the second layer part 136 is set between 40 and 65, which is beneficial for reducing the demolding difficulty. It should be noted that a special introduction to the cooling plate assembly of the application is provided above.

Specific examples are used in the context to explain the principles and implementation methods of the present application. The above examples are only used for understanding the core idea of the present application. It should be noted that for those skilled in the art, without departing from the principles of the present application, several improvements and modifications can be made to the present application, which also fall within the scope of the claims of the present application.

## Claims

1. A cooling plate assembly, **characterized by** comprising:
a first cooling plate (11);
a second cooling plate (12); and
a first connecting member (13),
wherein the second cooling plate (12) and the first cooling plate (11) each comprise a first match part (14), and the first connecting member (13) is configured to form a fluid-tight connection to the first match part (14);
the cooling plate assembly further comprises a position-limiting part (18), in an assembly direction of the first match parts (14) and the first connecting member (13), a relative movement of the first connecting member (13) and the first match parts (14) is restricted by the position-limiting part (18).

2. The cooling plate assembly according to claim 1, further comprising:
a first sealing part (15),
wherein the first match part (14) comprises a match portion (112), the first connecting member (13) comprises a connecting portion (111), and the first sealing part (15) is located and compressed between the connecting portion (111) and the match portion (112).

3. The cooling plate assembly according to claim 2, wherein
the match portion (112) comprises a large-diameter section (1311) and a small-diameter section (1312), the large-diameter section (1311) abuts against the first sealing part (15), and a gap is present between the small-diameter section (1312) and the connecting portion (111).

4. The cooling plate assembly according to any one of claims 1 to 3, comprising at least one first connecting member (13), at least one first match part (14), and at least one first sealing part (15), wherein,
in a radial direction of the first connecting member (13), one of an inner circumferential surface and an outer circumferential surface of the first connecting member (13) that is relatively close to the first match part (14) is defined as a first circumferential surface (132), in the radial direction of the first connecting member (13), one of an inner circumferential surface and an outer circumferential surface of the first match part (14) that is relatively close to the first connecting member (13) is defined as a second circumferential surface (142), the first circumferential surface (132) is connected with the first sealing part (15) for forming sealing, and the second circumferential surface (142) is connected with the first sealing part (15) for forming sealing;
the cooling plate assembly further comprises a first ribbed part (16), which is connected to the first connecting member (13) and/or the first match part (14); and
the first ribbed part (16) abuts against the first sealing part (15), or a gap is present between the first ribbed part (16) and the first sealing part (15) in an axial direction of the first connecting member (13).

5. The cooling plate assembly according to claim 4, wherein
the first sealing part (15) and the first connecting member (13) are integrally formed, the first ribbed part (16) and the first connecting member (13) are integrally formed, and both the first sealing part (15) and the first ribbed part (16) protrude out of the first circumferential surface (132); and
the first ribbed part (16) abuts against the first sealing part (15) in the axial direction of the first connecting member (13), the first connecting member (13) has a first end portion (133) in the axial direction of the first connecting member (13); and
the first sealing part (15) is arranged closer to the first end portion (133) than the first ribbed part (16), or, the first ribbed part (16) is arranged closer to the first end portion (133) than the first sealing part (15).

6. The cooling plate assembly according to claim 5, wherein
in the axial direction of the first connecting member (13), the first sealing part (15) is arranged closer to the first end portion (133) than the first ribbed part (16), the cooling plate assembly further comprises a second ribbed part (17), the second ribbed part (17) and the first connecting member (13) are integrally formed, and the second ribbed part (17) protrudes out of the first circumferential surface (132); and
in the axial direction of the first connecting member (13), the second ribbed part (17) is located on one side of the first sealing part (15), and the first ribbed part (16) is located on the other side of the first sealing part (15).

7. The cooling plate assembly according to claim 5 or 6, wherein
the first connecting member (13) is connected to two first match parts (14), the first connecting member (13) comprises a second section (138) and a first section (137), the first section (137) is assembled with the first match part (14) of the first cooling plate (11) and the second section (138) is assembled with the first match part (14) of the second cooling plate (12);
the first sealing part (15) comprises a first sub sealing part (151) and a second sub sealing part (152), the first ribbed part (16) comprises a first sub ribbed part (161) and a second sub ribbed part (162), the second sub sealing part (152) and the first section (137) are integrally formed, the second sub ribbed part (162) and the first section portion (137) are integrally formed, the first sub sealing part (151) and the second section portion (138) are integrally formed, and the first sub ribbed part (161) and the second section portion (138) are integrally formed;
in the axial direction of the first connecting member (13), the first sub sealing part (151) is arranged closer to the second cooling plate (12) than the first sub ribbed part (161), the second sub sealing part (152) is arranged closer to the first cooling plate (11) than the second sub ribbed part (162), the first sub sealing part (151) abuts against the first sub ribbed part (161), and the second sub sealing part (152) abuts against the second sub ribbed part (162); and
in the radial direction of the first connecting member (13), the first connecting member (13) is located on an outer periphery of each first match part (14); or, in the radial direction of the first connecting member (13), the first connecting member (13) is located on an inner periphery of each first match part (14); or, in the radial direction of the first connecting member (13), the first connecting member (13) is located on the inner periphery of one first match part (14) while on the inner periphery of the other first match part (14).

8. The cooling plate assembly according to claim 4, wherein
the first sealing part (15) and the first match part (14) are integrally formed, the first ribbed part (16) and the first match part (14) are integrally formed, and both the first sealing part (15) and the first ribbed part (16) protrude out of the second circumferential surface (142);
the first connecting member (13) has a second end portion (143) in the axial direction of the first match part (14), and in the axial direction of the first match part (14), the second end portion (143) is defined as one end of the first match part (14) that is relatively close to the first connecting member (13); and
in the axial direction of the first match part (14), the first ribbed part (16) is arranged closer to the second end portion (143) than the first sealing part (15); or, in the axial direction of the first match part (14), the first sealing part (15) is arranged closer to the second end portion (143) than the first ribbed part (16).

9. The cooling plate assembly according to claim 8, wherein,
in the axial direction of the first match part (14), the first sealing part (15) is arranged closer to the second end portion (143) than the first ribbed part (16);
the cooling plate assembly further comprises a second ribbed part (17), the second ribbed part (17) and the first match part (14) are integrally formed, and the second ribbed part (17) protrudes out of the second circumferential surface (142); and
in the axial direction of the first match part (14), the second ribbed part (17) is located on one side of the first sealing part (15), and the first ribbed part (16) is located on the other side of the first sealing part (15).

10. The cooling plate assembly according to claim 8 or 9, wherein
the first connecting member (13) is connected to two first match parts (14);
the first sealing part (15), the first ribbed part (16) and the two first match parts (14) are integrally formed, the first sealing part (15) is connected to the first connecting member (13) for forming sealing, and the first ribbed part (16) abuts against the first sealing part (15); and
in the radial direction of the first match parts (14), the two first match parts (14) are located on an outer periphery of the first connecting member (13); or, in the radial direction of the first match parts (14), the two first match parts (14) are located on an inner periphery of the first connecting member (13); or, in the radial direction of the two first match part (14), one first match part (14) is located on the outer periphery of one first connecting member (13) while the other first match part (14) is located on the inner periphery of the other first connecting member (13).

11. The cooling plate assembly according to any one of claims 4 to 10, wherein
a contact pressure between the first sealing part (15) and the first match part (14) or the first connecting member (13) is a first pressure, and a working pressure inside the first connecting member (13) is a second pressure;
in a circumferential direction of the first connecting member (13), an area where the first pressure is greater than the second pressure has a width not less than 0.6mm; and
in a direction perpendicular to the axial direction of the first connecting member (13), a positional difference between an axis of the first connecting member (13) and an axis of the first match part (13) is not greater than 3mm.

12. The cooling plate assembly according to claim 4, wherein
the first connecting member (13) is formed by means of a double-shot molding process, the first connecting member (13) comprises a first layer part (135) and a second layer part (136), the first layer part (135) and the second layer part (136) are fixedly connected, the first layer part (135) is located on an outer periphery of the second layer part (136), the first sealing part (15) and the second layer part (136) are integrally formed, and the first ribbed part (16) and the second layer part (136) are integrally formed; and
the first layer part (135) is made of plastic material, the second layer part (136) is made of elastic material, and the second layer part (136) has a Shore hardness A between 40 and 65.
